(19) **Europäisches Patentamt**
**European Patent Office**
**Office européen des brevets**

(11) **EP 4 530 269 A1**

(12) **EUROPEAN PATENT APPLICATION**

(43) Date of publication:
**02.04.2025 Bulletin 2025/14**

(21) Application number: **24165668.5**

(22) Date of filing: **22.03.2024**

(51) International Patent Classification (IPC):
***C03C 3/118*** (2006.01)    ***C03C 4/16*** (2006.01)
***C03C 13/00*** (2006.01)

(52) Cooperative Patent Classification (CPC):
**C03C 3/118; C03C 4/16; C03C 13/00;**
**H05K 1/0366; H01L 23/14**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **28.09.2023 TW 112137397**

(71) Applicant: **Fulltech Fiber Glass Corp.**
**Douliu City, Yunlin County (TW)**

(72) Inventors:
  • **Hsu, Hsien-Chung**
    **Douliu City, Yunlin County (TW)**

• **Chern, Bih-Cherng**
  **Douliu City, Yunlin County (TW)**
• **Chang, Ching-Shuo**
  **Douliu City, Yunlin County (TW)**
• **Chang, Chih-Yuan**
  **Douliu City, Yunlin County (TW)**
• **Lo, Wei-Chih**
  **Douliu City, Yunlin County (TW)**
• **Hsu, Wen-Ho**
  **Douliu City, Yunlin County (TW)**

(74) Representative: **Petraz, Gilberto Luigi et al**
**GLP S.r.l.**
**Viale Europa Unita, 171**
**33100 Udine (IT)**

(54) **GLASS COMPOSITION AND FIBERGLASS AND ELECTRONIC PRODUCT**

(57)     Provided is a glass composition, based on the total amount of the glass composition being 100 wt%, comprising a silicon oxide of 45 wt% to 61 wt%, an aluminum oxide of 15 wt% to 22 wt%, a calcium oxide of 0.1 wt% to 6 wt%, a magnesium oxide of greater than 0 wt% and less than 2 wt%, a zinc oxide of greater than 0 wt% and less than 8 wt%, a copper oxide of greater than 0 wt% and less than 7 wt% , a boron oxide of greater than 6 wt% and less than 18 wt%, and a content of the calcium oxide denoted by C, a content of the magnesium oxide denoted by M, a content of the aluminum oxide denoted by A, and a content of the boron oxide denoted by B satisfy formula [I]: $X = \dfrac{C+M}{A} + \dfrac{C+M}{B}$, the x value being 0.3 to 1.5.

**Description**

## BACKGROUND OF THE INVENTION

1. Field of the Invention

The present invention relates to a glass composition and its application, particularly to a glass composition having low thermal expansion coefficient, low dielectric constant, low dielectric loss tangent, and good spinning processability, a fiberglass comprising the glass composition, and an electronic product comprising the fiberglass.

2. Description of the Prior Arts

In response to the rapid changes in technological eras, existing electronic products all pursue high-speed transmission efficiency, and must also overcome the adverse effects of residual stress on existing electronic components caused by thermal expansion during operation. Therefore, a glass fiber cloth used as a reinforcing material in printed circuit boards not only needs to have low dielectric properties (low dielectric constant and low dielectric loss tangent) to meet high-speed transmission efficiency, but also needs to have low thermal expansion coefficient to make existing electronic products insusceptible to deformation under temperature changes.

The glass fiber cloth is woven from a glass fiber yarn, wherein the glass fiber yarn is formed from a fiberglass made by melting and spinning the glass composition. If the glass composition crystallizes during the production of the fiberglass, the spinning operation of the glass composition during the production of the fiberglass may not be smooth, which not only makes the quality of the produced fiberglass poor, but also causes negative effects on the properties of the fiberglass.

## SUMMARY OF THE INVENTION

Therefore, the first object of the present invention is to provide a glass composition that has low thermal expansion coefficient, low dielectric constant, low dielectric loss tangent, and good spinning processability.

The glass composition of the present invention comprises silicon oxide ($SiO_2$), aluminum oxide ($Al_2O_3$), calcium oxide (CaO), magnesium oxide (MgO), zinc oxide (ZnO), copper oxide (CuO) and boron oxide ($B_2O_3$).

Based on the total amount of the glass composition being 100 wt%, the content range of the silicon oxide is 45 wt% to 61 wt%, the content range of the aluminum oxide is 15 wt% to 22 wt%, the content range of the calcium oxide is 0.1 wt% to 6 wt%, the content range of the magnesium oxide is greater than 0 wt% and less than 2 wt%, the content range of the zinc oxide is greater than 0 wt% and less than 8 wt%, the content range of the copper oxide is greater than 0 wt% and less than 7 wt%, the content range of the boron oxide is greater than 6 wt% and less than 18 wt%, and a content of the calcium oxide denoted by C, a content of the magnesium oxide denoted by M, a content of the aluminum oxide denoted by A, and a content of the boron oxide denoted by B satisfy the following formula [I]:

$$\text{Formula [I]} \quad x = \frac{C+M}{A} + \frac{C+M}{B},$$

and x is 0.3 to 1.5.

The second object of the present invention is to provide a fiberglass with low thermal expansion coefficient, low dielectric constant, and low dielectric loss tangent.

Therefore, the fiberglass of the present invention comprises the abovementioned glass composition.

The third object of the present invention is to provide an electronic product that has good transmission efficiency and is insusceptible to deformation under temperature changes.

Therefore, the electronic product of the present invention comprises the abovementioned fiberglass.

The effect of the present invention is: through the combination of each component and its content in the glass composition of the present invention, especially the content range of the magnesium oxide is greater than 0 wt% and less than 2 wt%, and the contents of the calcium oxide, the magnesium oxide, the aluminum oxide, and the boron oxide satisfy the formula [I] (that is, the x value is 0.3 to 1.5), the glass composition has low thermal expansion coefficient, low dielectric constant, low dielectric loss tangent, and good spinning processability. Furthermore, since the glass composition of the present invention has good spinning processability, the fiberglass of the present invention produced from the glass composition and comprising the glass composition also has low thermal expansion coefficient, low dielectric constant, and low dielectric loss tangent, the electronic product of the present invention comprising the fiberglass has the advantages of good transmission efficiency and is insusceptible to deformation under temperature changes.

## DETAILED DESCRIPTION OF THE PREFERRED EMBODIMENTS

Hereinafter, the present invention is described in detail below.

[The glass composition]

The glass composition of the present invention comprises silicon oxide ($SiO_2$), aluminum oxide ($Al_2O_3$), calcium oxide (CaO), magnesium oxide (MgO), zinc oxide (ZnO), copper oxide (CuO) and boron oxide ($B_2O_3$).

Based on the total amount of the glass composition being 100 wt%, the content range of the silicon oxide is 45 wt% to 61 wt%, the content range of the aluminum oxide is 15 wt% to 22 wt%, the content range of the calcium oxide is 0.1 wt% to 6 wt%, the content range of the magnesium oxide is greater than 0 wt% and less than 2 wt%, the content range of the zinc oxide is greater than 0 wt% and less than 8 wt%, the content range of the copper oxide is greater than 0 wt% and less than 7 wt% , and the content range of the boron oxide is greater than 6 wt% and less than 18 wt%.

It should be noted in particular that after researching, testing, analyzing and summarizing the glass composition, the inventor designed that the content of the calcium oxide denoted by C, the content of the magnesium oxide denoted by M, the content of the aluminum oxide denoted by A, and the content of the boron oxide denoted by B satisfy the following formula [I]:

$$\text{Formula [I]} \quad x = \frac{C+M}{A} + \frac{C+M}{B},$$

and x is 0.3 to 1.5.

Through the design of the formula [I] and the x value, combined with the specific content range of each component in the glass composition of the present invention, especially the content range of the magnesium oxide is greater than 0 wt% and less than 2 wt%, the glass composition has low thermal expansion coefficient, low dielectric constant, low dielectric loss tangent, and good spinning processability.

The role played by each component and its content range in the present invention is described in detail below.

The silicon oxide is the main component of the glass composition, and the content range of the silicon oxide in the glass composition is 45 wt% to 61 wt%, which may reduce the viscosity of the glass composition, thereby being beneficial to the melting of the glass composition.

The content range of the aluminum oxide in the glass composition is 15 wt% to 22 wt%, which may not only reduce the viscosity of the glass composition and facilitate the melting of the glass composition, but also make the glass composition insusceptible to crystallization during the process of making the fiberglass, thereby having good spinning processability.

The content range of the calcium oxide in the glass composition is 0.1 wt% to 6 wt%, which may not only reduce the viscosity of the glass composition and facilitate the melting of the glass composition, may also make the glass composition insusceptible to crystallization during the process of making the fiber glass and have good spinning processability, and may even reduce the thermal expansion coefficient of the glass composition.

The content range of the magnesium oxide in the glass composition is greater than 0 wt% and less than 2 wt%, which may not only reduce the viscosity of the glass composition and facilitate the melting of the glass composition, but also make the structure of the glass composition become compact, so that the glass composition and the fiberglass produced from the glass composition have the advantages of low thermal expansion coefficient and low dielectric constant.

The content range of the zinc oxide in the glass composition is greater than 0 wt% and less than 8 wt%, which may reduce the thermal expansion coefficient of the glass composition and the fiberglass produced from the glass composition.

The content range of the copper oxide in the glass composition is greater than 0 wt% and less than 7 wt%, which may not only make the structure of the glass composition more compact and reduce the thermal expansion coefficient of the glass composition and the fiberglass produced from the glass composition, but also make the glass composition insusceptible to crystallization during the process of making the fiberglass, thereby having good spinning processability.

The content range of the boron oxide in the glass composition is greater than 6 wt% and less than 18 wt%, which may not only reduce the viscosity of the glass composition and facilitate the melting of the glass composition, but also make the glass composition insusceptible to crystallization during the process of making the fiberglass, thereby having good spinning processability, and may even make the structure of the glass composition more compact, so that the glass composition and the fiberglass produced from the glass composition have the advantages of low thermal expansion coefficient, low dielectric constant, and low dielectric loss tangent.

In some embodiments of the present invention, the glass composition also comprises fluorine ($F_2$), and based on the total amount of the glass composition being 100 wt%, the content range of the fluorine is greater than 0 wt% and less than 1 wt%. When the glass composition further comprises the fluorine, the content of the calcium oxide denoted by C, the content of the magnesium oxide denoted by M, the content of the aluminum oxide denoted by A, and the content of the boron oxide denoted by B still satisfy the formula [I]. In addition, the content of the calcium oxide denoted by C, the content of the magnesium oxide denoted by M, the content of the aluminum oxide denoted by A, the content of the boron oxide denoted by B and a content of the fluorine denoted by F also satisfy the following formula [II]:

$$\text{Formula [II]} \quad y = \frac{C+M}{A} + \frac{C+M}{B+F},$$

and y is 0.3 to 1.5.

The content range of the fluorine in the glass composition is greater than 0 wt% and less than 1 wt%, which may not only reduce the viscosity of the glass composition and facilitate the melting of the glass composition, but also impart the glass composition having advantages of lower dielectric constant and lower dielectric loss tangent.

In some embodiments of the present invention, the glass composition further comprises dopants. The dopants are impurities derived from other components in the glass composition. In some embodiments of the present invention, based on the total amount of the glass composition being 100 wt%, the content range of the dopants is less than 1.2 wt%. In some embodiments of the present invention, the dopants comprise at least one of sodium oxide ($Na_2O$), potassium oxide ($K_2O$), iron oxide ($Fe_2O_3$), and titanium dioxide ($TiO_2$).

In some embodiments of the present invention, the thermal expansion coefficient of the glass composition is less than 2.8 ppm/°C, the dielectric constant and the dielectric loss tangent at a frequency of 10 GHz are less than 4.9 and less than 0.0035 respectively, and a temperature of forming window of the glass composition is greater than 100°C. In some embodiments of the present invention, the dielectric constant at a frequency of 10 GHz may be more than or equal to 4.2 and less than 4.9, and the dielectric loss tangent at a frequency of 10 GHz may be more than or equal to 0.0018 and less than 0.0035. In some embodiments of the present invention, the dielectric loss tangent at a frequency of 10 GHz may be more than or equal to 0.0018 and less than or equal to 0.0031. The temperature of forming window of the glass composition being greater than 100°C means that the glass composition is beneficial to the spinning operation when manufacturing the fiberglass.

[The fiberglass]

The fiberglass of the present invention comprises a glass composition. The glass composition is as described above and would not be repeated again.

The preparation method of the fiberglass comprises, but is not limited to, the following steps: melting the glass composition to obtain a glass liquid, and then spinning the glass liquid to obtain a fiberglass. It should be noted that the condition parameters and specific processes for manufacturing the fiberglass are known in the relevant fields, and due to the differences in the content of each component in the glass composition, the relevant process condition parameters of the fiberglass may also be slightly different. The adjustment of the process condition parameters is also known to those skilled in the art, and therefore would not be described in detail.

Since the glass composition of the present invention has the advantages of low thermal expansion coefficient, low dielectric constant, low dielectric loss tangent, and good spinning processability, the fiberglass of the present invention which is produced from the glass composition and comprising the glass composition also has the characteristics of low thermal expansion coefficient, low dielectric constant, and low dielectric loss tangent. In some embodiments of the present invention, the thermal expansion coefficient of the fiberglass is below 2.8 ppm/°C, and the dielectric constant and dielectric loss tangent at a frequency of 10 GHz are less than 4.9 and less than 0.0035 respectively. In some embodiments of the present invention, the dielectric constant at a frequency of 10 GHz may be more than or equal to 4.2 and less than 4.9, and the dielectric loss tangent at a frequency of 10 GHz may be more than or equal to 0.0018 and less than 0.0035. In some embodiments of the present invention, the dielectric loss tangent at a frequency of 10 GHz may be more than or equal to 0.0018 and less than or equal to 0.0031.

[The electronic product]

The electronic product of the present invention comprises a fiberglass. The fiberglass is as described above and would not be repeated again. Since the fiberglass has the characteristics of low thermal expansion coefficient, low dielectric constant, and low dielectric loss tangent, the electronic product of the present invention made from the fiberglass and comprising the fiberglass has good transmission efficiency and is insusceptible to deformation under temperature changes.

The type of the electronic product does not need to be limited. As long as it is made from the fiberglass and comprises the fiberglass, it is an embodiment of the electronic product of the present invention. In some embodiments of the present invention, the electronic product is a printed circuit board. In some embodiments of the present invention, the electronic product is an integrated circuit carrier board. In some embodiments of the present invention, the electronic product is a radome.

The present invention would be further described with respect to the following embodiments, but it should be understood that the embodiments are only for illustration and should not be construed as limitations to the implementation of the present invention.

<Example 1>

Silicon oxide, aluminum oxide, calcium oxide, magnesium oxide, zinc oxide, copper oxide, boron oxide, and fluorine were mixed to prepare a glass composition. Based on a total amount of 100 wt%, the glass composition comprised 55.4 wt% of the silicon oxide, 18.0 wt% of the aluminum oxide, 2.3 wt% of the calcium oxide, 1.9 wt% of the magnesium oxide, 7.0 wt% of the zinc oxide, 0.2 wt% of the copper oxide, 14.0 wt% of the boron oxide, 0.7 wt% of the fluorine, and 0.5 wt% of the dopants (derived from the impurities comprised in the above components, including sodium oxide, potassium oxide, and iron oxide), wherein, the x value was 0.53, and the y value was 0.52.

**<Examples 2 to 7 and Comparative Examples 1 to 3>**

The preparation methods of Examples 2 to 7 and Comparative Examples 1 to 3 were mostly the same as the preparation method of Example 1, except that the contents of each component in the glass composition were different, as shown in Table 1 and Table 2. In addition, the dopants in the glass compositions of Examples 2 to 7 comprised sodium oxide, potassium oxide, and iron oxide; the dopants in the glass compositions of Comparative Examples 1 to 3 comprised sodium oxide, potassium oxide, iron oxide, and titanium dioxide.

**<Evaluation Items>**

The following evaluations were respectively performed on the glass compositions of Examples 1 to 7 and Comparative Examples 1 to 3. For clear explanation, the following testing procedures for the evaluation items were described using the glass composition of Example 1 as a representative. The remaining Examples and Comparative Examples were analyzed based on the same testing procedures. The evaluation results are shown in Table 1 and Table 2.

**The test of the thermal expansion coefficient (abbreviated as CTE, unit: ppm/°C)**

The glass composition of Example 1 was placed in a high-temperature furnace and heated at a temperature of 1500°C to 1600°C for 1 hour to 4 hours to obtain a completely molten glass liquid. The glass liquid was poured into a graphite crucible with a diameter of 40 mm, and placed in an annealing furnace preheated to 800°C to cool to room temperature (25°C) to obtain a glass block.

The glass block was cut and ground to obtain a test sample with a size of 0.5 cm×0.5 cm×2 cm. Then, a thermomechanical analyzer (brand: Hitachi; model: TMA71000) was used to heat the test sample at a temperature rising rate of 10°C/min, and the length change of the test sample at 50°C and 200°C was obtained, thereby obtaining the thermal expansion coefficient of the glass composition of Example 1.

**Tests of the dielectric constant (abbreviated as Dk) and the dielectric loss tangent (abbreviated as Df)**

The glass composition of Example 1 was placed in a high-temperature furnace and heated at a temperature of 1500°C to 1600°C for 1 hour to 4 hours to obtain a completely molten glass liquid. The glass liquid was poured into a graphite crucible with a diameter of 40 mm, and placed in an annealing furnace preheated to 800°C to cool to room temperature (25°C) to obtain a glass block.

The glass block was polished and ground to obtain a test specimen with a thickness ranging from 0.60 mm to 0.79 mm. Then, a vector network analyzer (brand: R&S; model: ZNB20) is used with a split post dielectric resonator (brand: Genie Networks) to measure the dielectric constant and the dielectric loss tangent of the test specimen under the condition of 10 GHz, thereby obtaining the dielectric constant and dielectric loss tangent of the glass composition of Example 1.

**Test of the temperature of forming window (abbreviated as $\Delta$T, unit: °C)**

The glass composition of Example 1 was placed in a high-temperature furnace and heated at a temperature of 1500°C to 1600°C for 1 hour to 4 hours to obtain a completely molten glass liquid. The glass liquid was poured into a graphite crucible with a diameter of 40 mm, and placed in an annealing furnace preheated to 800°C to cool to room temperature (25°C) to obtain a glass block.

2.25g of the glass block was taken and placed in the high-temperature furnace. Then the high-temperature furnace was heated to a specific temperature and maintained for 2 hours. Then the glass block was taken out of the high-temperature furnace and cooled to room temperature (25°C) to observe whether there were crystals in the glass block. If so, the specific temperature is the devitrification temperature of the glass composition of Example 1. Subtracting the devitrification temperature from the temperature of the glass composition of Example 1 at the viscosity of 1000 poise is the temperature of forming window of the glass composition of Example 1.

Table 1

| | | | Examples | | | | |
|---|---|---|---|---|---|---|---|
| | | | 1 | 2 | 3 | 4 | 5 |
| content (wt%) | | $SiO_2$ | 55.4 | 55.3 | 55.8 | 55.3 | 55.3 |
| | | $Al_2O_3$ | 18.0 | 18.0 | 18.3 | 18.2 | 17.2 |
| | | CaO | 2.3 | 2.3 | 2.3 | 2.3 | 2.3 |
| | | MgO | 1.9 | 1.9 | 1.9 | 1.9 | 1.9 |
| | | ZnO | 7.0 | 7.0 | 6.3 | 7.1 | 7.1 |
| | | CuO | 0.2 | 0.3 | 0.2 | 0.2 | 0.2 |
| | | $B_2O_3$ | 14.0 | 14.0 | 14.0 | 14.0 | 15.0 |
| | | $F_2$ | 0.7 | 0.7 | 0.7 | 0.5 | 0.5 |
| | | dopants | 0.5 | 0.5 | 0.5 | 0.5 | 0.5 |
| | | total | 100 | 100 | 100 | 100 | 100 |
| $x = \dfrac{C + M}{A} + \dfrac{C + M}{B}$ | | | 0.53 | 0.53 | 0.53 | 0.53 | 0.52 |
| $y = \dfrac{C + M}{A} + \dfrac{C + M}{B + F}$ | | | 0.52 | 0.52 | 0.52 | 0.52 | 0.52 |
| thermal expansion coefficient (ppm/°C) | | | 2.74 | 2.74 | 2.78 | 2.68 | 2.79 |
| 10GHz | dielectric constant | | 4.83 | 4.87 | 4.86 | 4.89 | 4.83 |
| | dielectric loss tangent | | 0.0030 | 0.0030 | 0.0029 | 0.0032 | 0.0029 |
| temperature of forming window, $\Delta T$ (°C) | | | >100 | >100 | >100 | >100 | >100 |
| [Note] "C" refers to the content of CaO ; "M" refers to the content of MgO; "A" refers to the content of $Al_2O_3$ ; "B" refers to the content of $B_2O_3$; "F" refers to the content of $F_2$. | | | | | | | |

Table 2

| | | | Examples | | Comparative Examples | | |
|---|---|---|---|---|---|---|---|
| | | | 6 | 7 | 1 | 2 | 3 |
| content (wt%) | | $SiO_2$ | 55.7 | 55.5 | 57.0 | 59.3 | 55.4 |
| | | $Al_2O_3$ | 17.8 | 17.2 | 19.4 | 18.5 | 18.2 |
| | | CaO | 1.9 | 2.9 | 0.4 | 5.5 | 2.0 |
| | | MgO | 1.9 | 0.9 | 1.9 | 1.9 | 2.2 |
| | | ZnO | 7.0 | 7.1 | 2.0 | 1.0 | 7.0 |
| | | CuO | 0.2 | 0.2 | 0.5 | 6.5 | 0.2 |
| | | $B_2O_3$ | 15.0 | 15.2 | 17.8 | 6.3 | 14.0 |
| | | $F_2$ | 0 | 0.5 | 0 | 0 | 0 |
| | | dopants | 0.5 | 0.5 | 1.0 | 1.0 | 1.0 |
| | | total | 100 | 100 | 100 | 100 | 100 |
| $x = \dfrac{C + M}{A} + \dfrac{C + M}{B}$ | | | 0.47 | 0.47 | 0.25 | 1.57 | 0.53 |
| $y = \dfrac{C + M}{A} + \dfrac{C + M}{B + F}$ | | | 0.47 | 0.46 | 0.25 | 1.57 | 0.53 |
| thermal expansion coefficient (ppm/°C) | | | 2.70 | 2.77 | 2.66 | 2.54 | 2.64 |
| 10GHz | | dielectric constant | 4.89 | 4.86 | 4.66 | 5.30 | 4.96 |
| | | dielectric loss tangent | 0.0034 | 0.0033 | 0.0032 | 0.0069 | 0.0040 |
| temperature of forming window, $\Delta T$ (°C) | | | >100 | >100 | <50 | - | - |

[Note] "C" refers to the content of CaO; "M" refers to the content of MgO; "A" refers to the content of $Al_2O_3$ ; "B" refers to the content of $B_2O_3$; "F" refers to the content of $F_2$; "--" refers untested, which is because, Comparative Examples 2 and 3 have high dielectric constant and dielectric loss tangent at a frequency of 10GHz, so the test of the temperature of forming window is not continued.

As seen from Table 1 and Table 2, compared with the glass composition of Comparative Example 1 whose x value is less than 0.3 such that the temperature of forming window is less than 50°C, which is not beneficial to the spinning operation when manufacturing the fiberglass, and compared with the glass composition of Comparative Example 2 whose x value is greater than 1.5 such that the dielectric constant and the dielectric loss tangent at a frequency of 10 GHz are both high, since the glass compositions of Examples 1 to 7 satisfy formula [I] (which is, the x value is between 0.3 and 1.5), its thermal expansion coefficient, dielectric constant and dielectric loss tangent at a frequency of 10GHz, and the temperature of forming window are all better.

Compared to the glass composition of Comparative Example 3, the dielectric constant and the dielectric loss tangent at a frequency of 10 GHz are both high because the magnesium oxide content is more than 2 wt%. Since the magnesium oxide of the glass compositions of Examples 1 to 7 are greater than 0 wt% and less than 2 wt%, the thermal expansion coefficient, dielectric constant and dielectric loss tangent at a frequency of 10GHz, and the temperature of forming window are all better.

Combining the above results, it is seen that the glass compositions of Examples 1 to 7 fully meet the requirements of "based on the total amount of the glass composition being 100wt%, the content range of the silicon oxide is 45 wt% to 61 wt%, the content range of the aluminum oxide is 15 wt% to 22 wt%, the content range of the calcium oxide is 0.1 wt% to 6 wt%, the content range of the magnesium oxide is greater than 0 wt% and less than 2 wt%, the content range of the zinc oxide is greater than 0 wt% and less than 8 wt%, the content range of the copper oxide is greater than 0 wt% and less than 7 wt%, the content range of the boron oxide is greater than 6 wt% and less than 18 wt%, satisfying the requirement of the formula [I] (that is, the x value is between 0.3 and 1.5)", such that its thermal expansion coefficient is less than 2.8ppm/°C, the dielectric constant and the dielectric loss tangent at a frequency of 10GHz are less than 4.9 and less than 0.0035 respectively, and the temperature of forming window is greater than 100°C, proving that the glass composition of the present invention has the effects of low thermal expansion coefficient, low dielectric constant, low dielectric loss tangent, and good spinning processability.

In summary, through the combination of each component and its content range in the glass composition of the present invention, especially the content range of the magnesium oxide is greater than 0 wt% and less than 2 wt%, and the contents of the calcium oxide, the magnesium oxide, the aluminum oxide, and the boron oxide of the glass composition satisfy the design of the formula [I] (that is, the x value is between 0.3 and 1.5), the glass composition has low thermal expansion coefficient, low dielectric constant, low dielectric loss tangent, and good spinning processability, showing that the purpose of the present invention can indeed be achieved. Furthermore, since the glass composition of the present invention has good spinning processability, the fiberglass of the present invention produced from the glass composition and comprising the glass composition also has low thermal expansion coefficient, low dielectric constant, and low dielectric loss tangent, such that the electronic product of the present invention comprising the fiberglass has the advantages of good transmission efficiency and is insusceptible to deformation under temperature changes.

However, the above are only examples of the present invention. They cannot be used to limit the scope of the present invention. Any simple equivalent changes and modifications made based on the scope of the claims of the present invention and the contents of the specification are still within the scope covered by the present invention.

## Claims

1. A glass composition, based on the total amount of the glass composition being 100 wt%, comprising:

   a silicon oxide of 45 wt% to 61 wt%,
   an aluminum oxide of 15 wt% to 22 wt%,
   a calcium oxide of 0.1 wt% to 6 wt%,
   a magnesium oxide of greater than 0 wt% and less than 2 wt%,
   a zinc oxide of greater than 0 wt% and less than 8 wt%,
   a copper oxide of greater than 0 wt% and less than 7 wt%,
   a boron oxide of greater than 6 wt% and less than 18 wt%,
   and a content of the calcium oxide denoted by C, a content of the magnesium oxide denoted by M, a content of the aluminum oxide denoted by A, and a content of the boron oxide denoted by B satisfy the following formula 111:

   $$\text{Formula [I]} \quad x = \frac{C+M}{A} + \frac{C+M}{B},$$

   **characterized in that** a value of x is 0.3 to 1.5.

2. The glass composition as claimed in claim 1, **characterized in that** the glass composition also comprises a fluorine, and based on the total amount of the glass composition being 100 wt%, the content range of the fluorine is greater than 0 wt% and less than 1 wt%.

3. The glass composition as claimed in claim 2, **characterized in that** the content of the calcium oxide denoted by C, the content of the magnesium oxide denoted by M, the content of the aluminum oxide denoted by A, the content of the boron oxide denoted by B, and a content of the fluorine denoted by F satisfy the following formula [II]:

   $$\text{Formula [II]} \quad y = \frac{C+M}{A} + \frac{C+M}{B+F},$$

   **characterized in that** a value of y is 0.3 to 1.5.

4. A fiberglass comprising the glass composition as claimed in any one of claims 1 to 3.

5. An electronic product comprising the fiberglass as claimed in claim 4.

6. The electronic product as claimed in claim 5, **characterized in that** the electronic product is a printed circuit board.

7. The electrolytic product as claimed in claim 5, **characterized in that** the electronic product is an integrated circuit carrier board.

8. The electronic product as claimed in claim 5, **characterized in that** the electronic product is a radome.

Europäisches
Patentamt

European
Patent Office

Office européen
des brevets

# EUROPEAN SEARCH REPORT

Application Number

EP 24 16 5668

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/206687 A1 (HSU WEN-HO [TW] ET AL) 8 July 2021 (2021-07-08) * paragraph [0002]; table 1 * | 1-8 | INV. C03C3/118 C03C4/16 C03C13/00 |
| X | DE 101 30 214 A1 (THUERINGER FILTER GLAS GMBH & [DE]) 16 January 2003 (2003-01-16) * paragraphs [0002], [0019] * | 1-8 | |
| X | US 4 824 806 A (YOKOI KOJI [JP] ET AL) 25 April 1989 (1989-04-25) * column 1, line 8 - line 11; example 2; table 1 * | 1,4-8 | |
| X | US 2020/216351 A1 (HAUSRATH ROBERT LURIE [US] ET AL) 9 July 2020 (2020-07-09) * paragraph [0002]; example 94; table 10 * | 1,4-8 | |
| X | JP 2007 217280 A (NIPPON SHEET GLASS CO LTD; MAG KK) 30 August 2007 (2007-08-30) * the whole document * | 1,4 | |
| X | JP 2018 048057 A (NIPPON ELECTRIC GLASS CO) 29 March 2018 (2018-03-29) * the whole document * | 1 | **TECHNICAL FIELDS SEARCHED (IPC)** C03C H01Q |

The present search report has been drawn up for all claims

| Place of search | Date of completion of the search | Examiner |
|---|---|---|
| Munich | 10 October 2024 | King, Ruth |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 5668

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2024

| Patent document cited in search report | | Publication date | Patent family member(s) | | Publication date |
|---|---|---|---|---|---|
| US 2021206687 | A1 | 08-07-2021 | CN | 112047626 A | 08-12-2020 |
| | | | JP | 6983971 B2 | 17-12-2021 |
| | | | JP | 2021109821 A | 02-08-2021 |
| | | | TW | 202016040 A | 01-05-2020 |
| | | | US | 2021206687 A1 | 08-07-2021 |
| DE 10130214 | A1 | 16-01-2003 | NONE | | |
| US 4824806 | A | 25-04-1989 | BE | 1000198 A3 | 23-08-1988 |
| | | | DE | 3709868 A1 | 08-10-1987 |
| | | | FR | 2596387 A1 | 02-10-1987 |
| | | | GB | 2189481 A | 28-10-1987 |
| | | | IT | 1203408 B | 15-02-1989 |
| | | | JP | S62226839 A | 05-10-1987 |
| | | | US | 4824806 A | 25-04-1989 |
| US 2020216351 | A1 | 09-07-2020 | NONE | | |
| JP 2007217280 | A | 30-08-2007 | NONE | | |
| JP 2018048057 | A | 29-03-2018 | JP | 6913275 B2 | 04-08-2021 |
| | | | JP | 2018048057 A | 29-03-2018 |

EPO FORM P0459

For more details about this annex : see Official Journal of the European Patent Office, No. 12/82